# EUROPÄISCHE PATENTSCHRIFT

(11) **EP 0 900 473 B1**
(45) Veröffentlichungstag und Bekanntmachung des Hinweises auf die Patenterteilung: **23.07.2003**
(21) Anmeldenummer: 97923797.1
(22) Anmeldetag: 09.05.1997
(51) Int. Cl.: H02M 7/00

(54) **ANTRIEBSVORRICHTUNG FÜR WALZGERÜSTE**
DRIVE DEVICE FOR ROLL STANDS
DISPOSITIF D'ENTRAINEMENT POUR CAGES DE LAMINOIR

(30) Priorität: 21.05.1996 DE 19620246; 27.09.1996 DE 19639962
(43) Veröffentlichungstag der Anmeldung: 10.03.1999
(73) Patentinhaber: SIEMENS AKTIENGESELLSCHAFT, 80333 München (DE)
(72) Erfinder: SALZMANN, Theodor, D-91080 Spardorf (DE); WOKUSCH, Johann, D-91301 Forchheim (DE); KLUG, Rolf-Dieter, D-90427 Nürnberg (DE)
(86) Internationale Anmeldenummer: DE9700945
(87) Internationale Veröffentlichungsnummer: WO97044888

(56) Entgegenhaltungen:
- US-A- 4 015 173
- US-A- 4 691 274
- US-A- 4 864 385
- D.W.DRAPER ET AL.: "Thyristor-supplied tandem cold mill" PROCEEDINGS OF THE INSTITUTION OF ELECTRICAL ENGINEERS, Bd. 115, Nr. 10, Oktober 1968, Seiten 1513-1522, XP002039913
- L.BALA KRISHNAN: "Economic factors governing the specification and selection of electrical equipment for large reversing drives in rolling mills. " ASEA JOURNAL, Bd. 46, Nr. 4, 1973, Seiten 85-88, XP002039914
- WERNER SCHULZ ET AL.: "Logidyn für Antriebe in Industrieanlagen unter besonderer Berücksichtigung des Thyristor-Leistungsteils" TECHNISCHE MITTEILUNGEN, Bd. 62, Nr. 4/5, 1972, Seiten 202-212, XP002039915
- KARLHEINZ HERRMANN: "Electrical equipment for a highly automated cold mill." ABB REVIEW, Nr. 5, 1991, ZURICH, CH, Seiten 13-20, XP000240576
- RALPH C. LACH ET AL.: "Paralleling Hot Strip Mill M-G Sets With SCR's for Additional Power." IRON AND STEEL ENGINEER, August 1971, Seiten 89-94, XP002039916
- K. MOLL: "VERIVERT K subsynchronous converter cascades" BROWN BOVERI REVIEW, Bd. 74, Nr. 8, August 1987, CH, Seiten 459-466, XP002040414
- WERNER PHILIPS: "Thyristorspeisung von Kaltwalzwerk-Antrieben" BBC-NACHRICHTEN, Bd. 52, Nr. 10/11, November 1970, Seiten 315-321, XP002039917
- PATENT ABSTRACTS OF JAPAN vol. 11, no. 286 (E-541), 16.September 1987 & JP 62 086639 A (MATSUSHITA ELECTRONICS), 21.April 1987,
- "Driving mills with alternating current" STEEL TIMES INCORPORATING IRON & STEEL, Bd. 219, Nr. 6, Juni 1991, SURREY, GB, Seite 322 XP000213875
- G. FISHER ET AL.: "Design and operational behaviour of air cooled high power 3-level-inverter with reverse conducting GTO's." PCIM '96 EUROPE. OFFICIAL PROCEEDINGS OF THE THIRTY-SECOND INTERNATIONAL POWER CONVERSION CONFERENCE, 21.Mai 1996, NURNBERG, DE, Seiten 623-628, XP002040415

## Beschreibung

Die Erfindung betrifft eine Antriebseinrichtung für Walzgerüste eines Walzwerkes, wobei die Antriebseinrichtung zumindest einen Drehstrommotor aufweist, der zumindest über einen Umrichter im Megawattbereich mittels eines Transformators aus einem Energieversorgungsnetz versorgt wird.

Es ist bekannt, Antriebseinrichtungen für Walzgerüste eines Walzwerkes, die jeweils einen Spannungszwischenkreis-Umrichter mit einem nachgeschalteten Drehstrommotor aufweisen, wassergekühlt auszuführen. Derartige wassergekühlte Antriebseinrichtungen sind jedoch in bezug auf Herstellung und Wartung teuer. Eine Luftkühlung für derartige Umrichter für Antriebe von Walzgerüsten, die insbesondere in einem Leistungsbereich von 1 bis 20 MW betrieben werden, gilt als nicht geeignet.

Aus der Veröffentlichung "Thyristor-supplied tandem cold mill", abgedruckt in der Zeitschrift "Proceedings of the Institution of Electrical Engineers", Vol. 115, No. 10, Oktober 1968, ist eine Antriebseinrichtung für Walzgerüste eines Walzwerkes bekannt, die luftgekühlt ausgeführt ist. Diese bekannte Antriebseinrichtung weist eine stromrichtergespeiste fremderregte Gleichstrommaschine auf. Der zur Speisung vorgesehene Stromrichter weist Thyristor-Leistungsteile auf, die luftgekühlt werden. Mit Hilfe eines derartigen Thyristor-Stromrichters wird aus einer Wechselspannung fester Frequenz und Amplitude eine einstellbare Gleichspannung generiert. Dazu wird jeder Thyristor pro Netzperiode nur einmal angesteuert (Phasenanschnittsteuerung). Deshalb kann ein derartiger Thyristor-Stromrichter im Megawattbereich luftgekühlt werden.

Eine derartige Antriebseinrichtung für Walzgerüste eines Walzwerks, die eine fremderregte Gleichstrommaschine und einen luftgekühlten Thyristor-Stromrichter aufweist, ist ebenfalls in der Veröffentlichung "Economic factors govering the specification and selection of electrical equipment for large reversing drives in rolling mills", abgedruckt in der Zeitschrift "ASEA Journal", Band 46, Nr. 4, 1973, Seiten 85 bis 89, beschrieben.

Aufgabe der Erfindung ist es, eine Antriebseinrichtung für Walzgerüste eines Walzwerkes anzugeben, die gegenüber den bekannten Antriebseinrichtungen in diesem Leistungsbereich günstiger in der Herstellung ist.

Dabei ist es außerdem wünschenswert, eine Antriebseinrichtung für Walzgerüste eines Walzwerkes anzugeben, die gegenüber den bekannten Antriebseinrichtungen einfacher und kostengünstiger zu betreiben und zu warten ist.

Diese Aufgabe wird erfindungsgemäß durch eine Antriebseinrichtung gemäß den Merkmalen des Anspruchs 1 gelöst.

Dadurch, dass ein Spannungszwischenkreis-Umrichter in Dreipunktschaltung vorgesehen ist, der abschaltbare Leistungshalbleiter aufweist, die mit einer niedrigen bis mittleren Schaltfrequenz arbeiten, kann dieser Umrichter im Megawattbereich luftgekühlt werden. Mittels diesem luftgekühlten Spannungszwischenkreis-Umrichter wird aus einem Energieversorgungsnetz mit konstanter Frequenz und Amplitude eine dreiphasige Wechselspannung mit variabler Frequenz und Amplitude für einen Drehstrommotor der Antriebseinrichtung für ein Walzgerüst im Megawattbereich günstig generiert. Außerdem ist ein derartig luftgekühlter Umrichter gegenüber einem wassergekühlten

Umrichter im oben genannten Leistungsbereich besonders kostengünstig und wartungsarm.

Beim erfindungsgemäßen luftgekühlten Spannungszwischenkreis-Umrichter verbinden Kühlkörper einzelne abschaltbare Leistungshalbleiter elektrisch. Diese elektrische Verbindung stellt ebenfalls eine gute thermische Verbindung dar, so daß die in den Leistungshalbleitern abfallende Wärme in ausreichender Weise abgeführt wird. Dabei hat es sich weiterhin als vorteilhaft erwiesen, Kühlkörper mit einer derart hohen thermischen Kapazität zu verwenden, daß die Kühlkörper bei Belastungsspitzen thermisch träge reagieren.

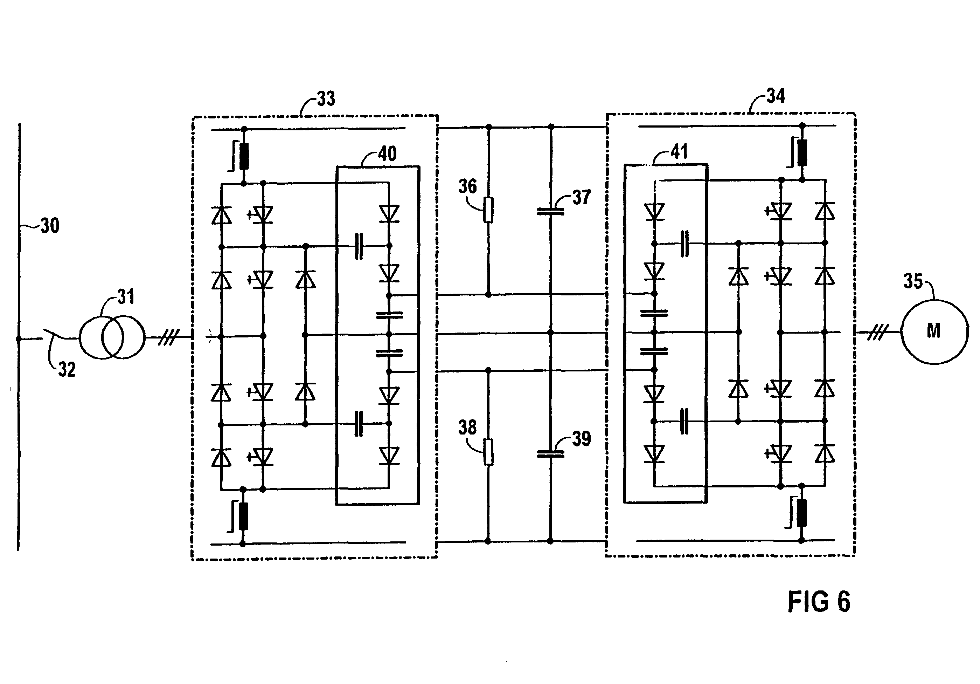

Weist die erfindungsgemäße Antriebseinrichtung einen Drehstrommotor mit einer offenen Wicklung auf, auch als Tandemschaltung bezeichnet, so eignet sich die erfindungsgemäße Antriebseinrichtung besonders vorteilhaft für niedrige Schaltfrequenzen < 100 Hz. Bei Spannungszwischenkreis-Umrichtern in Dreipunktschaltung, wie er z.B. in FIG 6 gezeigt ist, kommt die erfindungsgemäße Antriebseinrichtung bei mittleren Schaltfrequenzen des Umrichters < 250 Hz besonders vorteilhaft zum Einsatz.

Weitere Vorteile und erfinderische Einzelheiten ergeben sich aus der nachfolgenden Beschreibung von Ausführungsbeispielen, anhand der Zeichnung und in Verbindung mit den Unteransprüchen. Im einzelnen zeigen:
- FIG 1: einen umrichtergespeisten Motor mit Diodengleichrichter auf der Netzseite,
- FIG 2: einen umrichtergespeisten Motor mit selbstgeführtem Gleich- und Wechselrichter auch auf der Netzseite,
- FIG 3: eine Umrichteranordnung mit über Lichtwellenleiter verbundenem Automatisierungsgerät,
- FIG 4: einen Dreipunktwechselrichter mit GTO-Thyristoren (Hauptstromkreis ohne Beschaltung),
- FIG 5: einen Dreipunktwechselrichter-Baustein mit RC-GTO's und Beschaltungsnetzwerk,
- FIG 6: eine Umrichteranordnung zur Speisung eines Drehstrommotors mit Teilumrichter in Dreipunktschaltung auf der Netz- und Maschinenseite,
- FIG 7: eine Umrichteranordnung zur beidseitigen Speisung eines Drehstrommotors mit offener Wicklung mit Teilumrichter in Dreipunktschaltung,
- FIG 8: den mechanischen Aufbau eines erfindungsgemäßen Umrichters,
- FIG 9: den Einsatz eines erfindungsgemäßen Umrichters in einem Walzwerk.

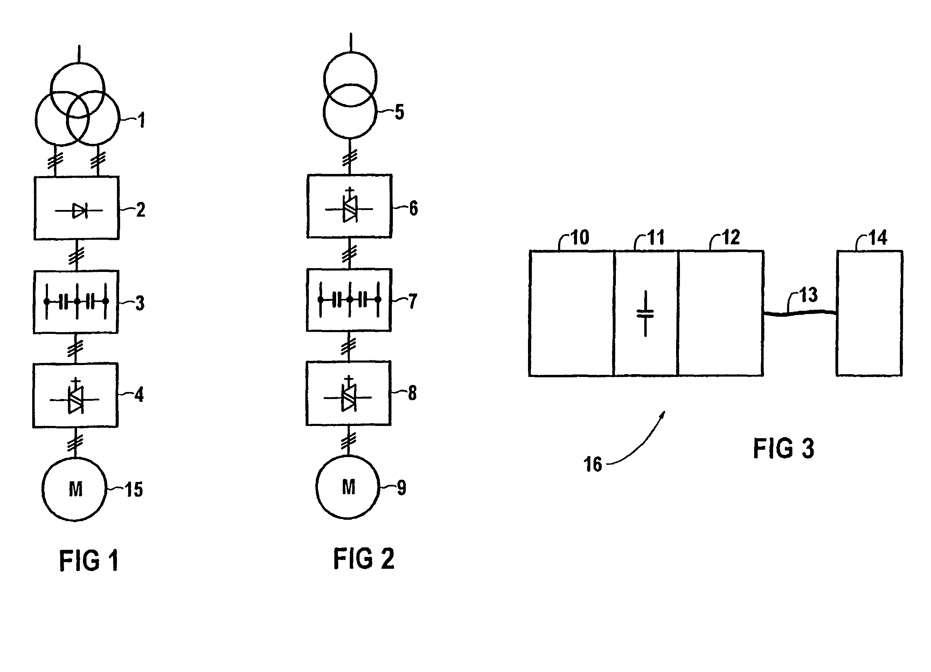

In FIG 1 ist ein umrichtergespeister Motor 15 mit Diodengleichrichter 2 auf der Netzseite dargestellt. Die Umrichteranordnung ist vorzugsweise als Reihenschaltung zweier B6-Diodenbrücken ausgeführt. Die netzseitige Anbindung erfolgt über einen Transformator 1 mit zwei vorzugsweise um elektrisch 30° versetzten Sekundärwicklungssystemen zur Erzielung einer 12-pulsigen Netzrückwirkung. Der Diodengleichrichter 2 ist auf der Gleichspannungsseite über den Spannungszwischenkreis 3 mit dem maschinenseitigen Wechselrichter 4 verbunden. Die Zwischenkreisverbindung erfolgt vorzugsweise über drei Pole, den positiven und negativen Zwischenkreispol sowie dem Gleichspannungsmittelpunkt. Der maschinenseitige Wechselrichter 4 ist als selbstgeführter Wechselrichter in Dreipunktschaltung ausgeführt an dessen Ausgangsseite über drei Leiter der Drehstrommotor 15 angeschlossen ist.

In FIG 2 ist ein umrichtergespeister Motor 9 mit selbstgeführtem Gleich- und Wechselrichter 6 und 8 auch auf der Netzseite dargestellt. Die Umrichteranordnung besteht aus einem netzseitigen selbstgeführten Gleichrichter 6, der auf der Gleichspannungsseite über den Spannungszwischenkreis 7 mit dem maschinenseitigen Wechselrichter 8 verbunden ist. Beide Teilumrichter 6 und 8 sind in Dreipunktschaltung ausgeführt und die Zwischenkreisverbindung erfolgt vorzugsweise über drei Pole, dem positiven und negativen Zwischenkreis sowie dem Gleichspannungsmittelpunkt. Der netzseitige selbstgeführte Gleichrichter 6 ist über den Transformator 5 mit dem Netz verbunden. Die Schaltung ist vorzugsweise gleich der des maschinenseitigen Wechselrichters 8 ausgeführt und ermöglicht sowohl den Betrieb als Gleichrichter als auch als Wechselrichter zur Energierückspeisung z.B. im Bremsbetrieb des Motors 9. Der maschinenseitige Wechselrichter ist an seiner Ausgangsseite über drei Leiter mit dem Drehstrommotor verbunden.

Die FIG 3 zeigt eine Umrichteranordnung mit einem Automatisierungsgerät 14 zur Steuerung des Umrichters 16, wobei der gesamte Informationsaustausch über eine Lichtwellenleiterverbindung 13 erfolgt. Der Umrichter 16 weist einen netzseitigen Teilumrichter 10, einen Spannungszwischenkreis 11 und einen maschinenseitigen Teilumrichter 12 auf. Die Leistungsverbindungen der Teilumrichter mit dem Netz und dem Motor können z.B. nach FIG 1 und FIG 2 erfolgen. Der Umrichter 10 enthält alle für den Betrieb und die Überwachung benötigten Sensoren, so daß keine weitere Verbindung zum Umfeld erforderlich ist. Nicht dargestellt ist, daß sowohl der Umrichter als auch das Automatisierungsgerät eine Hilfsstromversorgung oder Batterie benötigt.

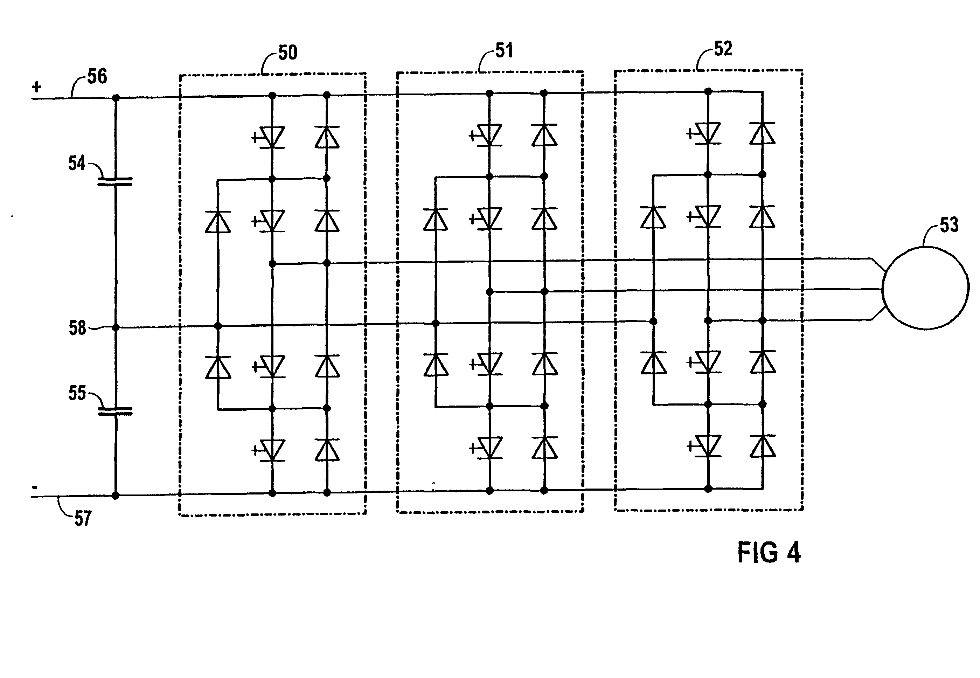

Die FIG 4 zeigt den Hauptstromkreis eines Dreipunktwechselrichters. Zwischen dem positiven Gleichspannungspol 56 und dem negativen Gleichspannungspol 57 sind der P-seitige Zwischenkreiskondensator 54 und der N-seitige Zwischenkreiskondensator 55 in Reihe geschaltet. Ihr Verbindungspunkt bildet den Gleichspannungsmittelpunkt 58. Die Phasenbausteine 50,51,52 mit jeweils vier in Reihe geschalteten GTO's und gegenparallel geschalteten Freilaufdioden sind jeweils zwischen den positiven und negativen Gleichspannungspol geschaltet. Der Verbindungspunkt zwischen dem ersten und zweiten GTO eines Phasenbausteins und dem dritten und vierten GTO eines Phasenbausteins ist jeweils über zusätzlich zwei in Reihe geschaltete gegenparallel zu den GTO's liegende Dioden verbunden, der Mittelpunkt dieser beiden Dioden ist jeweils mit dem Gleichspannungsmittelpunkt 58 verbunden. Der Verbindungspunkt zwischen dem zweiten und dritten GTO eines Phasenbausteins bildet die jeweilige Ausgangsklemme, die mit dem Motor 53 verbunden ist.

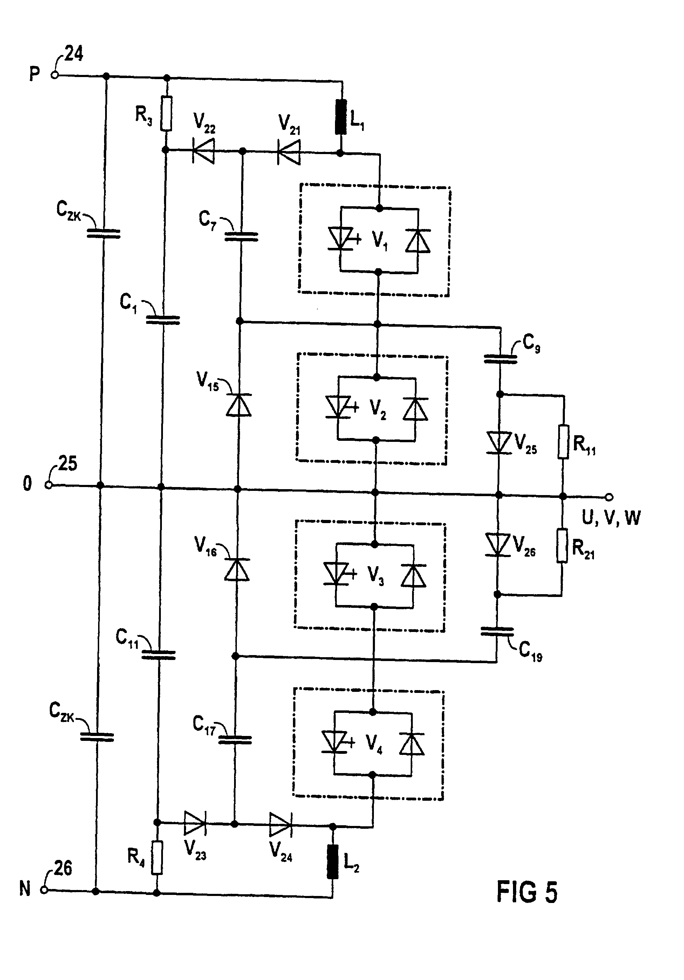

Die FIG 5 zeigt einen Dreipunktwechselrichter-Baustein mit RC-GTO's und Beschaltungsnetzwerk. Die Reihenschaltung einer Induktivität L1, der vier RC-GTO's (Reverse Conducting Gate-Turn-Off-Thyristoren) V1,V2,V3,V4 und der Induktivität L2 zwischen dem positiven Gleichspannungspol 24 und dem negativen Gleichspannungspol 26 bilden zusammen mit den beiden Mittelpunktdioden V15 und V16 den Hauptstromkreis eines Phasenbausteins eines Dreipunktwechselrichters. Dabei ist V15 mit der Anode mit dem Gleichspannungsmittelpunkt 25 und der Kathode mit dem Verbindungspunkt des ersten RC-GTO's V1 mit dem zweiten RC-GTO V2 verbunden. X16 ist mit der Kathode mit dem Gleichspannungsmittelpunkt 25 und der Anode mit dem Verbindungspunkt des dritten RC-GTO's V3 mit dem vierten RC-GTO V4 verbunden. Der Verbindungspunkt zwischen dem zweiten RC-GTO V2 und dem dritten RC-GTO V3 bildet den Wechselspannungsausgang des Phasenbausteins V (V oder W).

L1 und L2 dienen zur Begrenzung der Stromanstiegsgeschwindigkeit, die Beschaltungsnetzwerke V21 und V22 mit C7 und C1 sowie V24 und V23 mit C17 und C11 dienen zur Begrenzung der Spannungsanstiegsgeschwindigkeit beim Schalten der GTO's. Zu den Widerständen R3 und R4 wird die im jeweiligen Beschaltungsnetzwerk je Schaltvorgang gespeicherte Energie in Wärme umgesetzt und die Überladung der Kondensatoren C1 und C11 verhindert bzw. zurückgeführt.

Die beiden RCD-Beschaltungsnetzwerke R11,C9,V25 bzw. R21,C19, V26 dienen als Zusatzbeschaltung der beiden mittleren RC-GTO's V2 und V3. Sie werden vorteilhafterweise bei Umrichtern hoher Leistung mit daraus resultierenden großen mechanischen Abmessungen eingesetzt, um Überspannungen an aufbaubedingten parasitären Induktivitäten von den GTO's V2 und V3 zu vermeiden.

FIG 6 zeigt eine Umrichteranordnung zur Speisung einer Drehstrommaschine, wobei der netzseitige Teilumrichter 33 und der motorseitige Teilumrichter 34 mit GTO's in Dreipunktschaltung, jeweils gleich, ausgeführt sind. Es ist jeweils der Hauptstromkreis eines Phasenbausteins mit seinem Beschaltungsnetzwerk 40 bzw.41 dargestellt. Der P-seitige Zwischenkreiskondensator 37 bildet gemeinsam mit dem N-seitigen Zwischenkreiskondensator 39 den Gleichspannungszwischenkreis, über den die beiden Teilumrichter verbunden sind. Der P-seitige Beschaltungsrückladewiderstand 36 und der N-seitige Beschaltungsrückladewiderstand 38 sind mit der jeweiligen Seite der Beschaltungsnetzwerke 40 bzw.41 verbunden.
Der netzseitige Teilumrichter 33 ist ausgangsseitig über den Transformator 31 und dem Leistungsschalter 32 mit dem Netz 30 verbunden. Der maschinenseitige Teilumrichter 34 ist ausgangsseitig mit dem Drehstrommotor 35 verbunden.

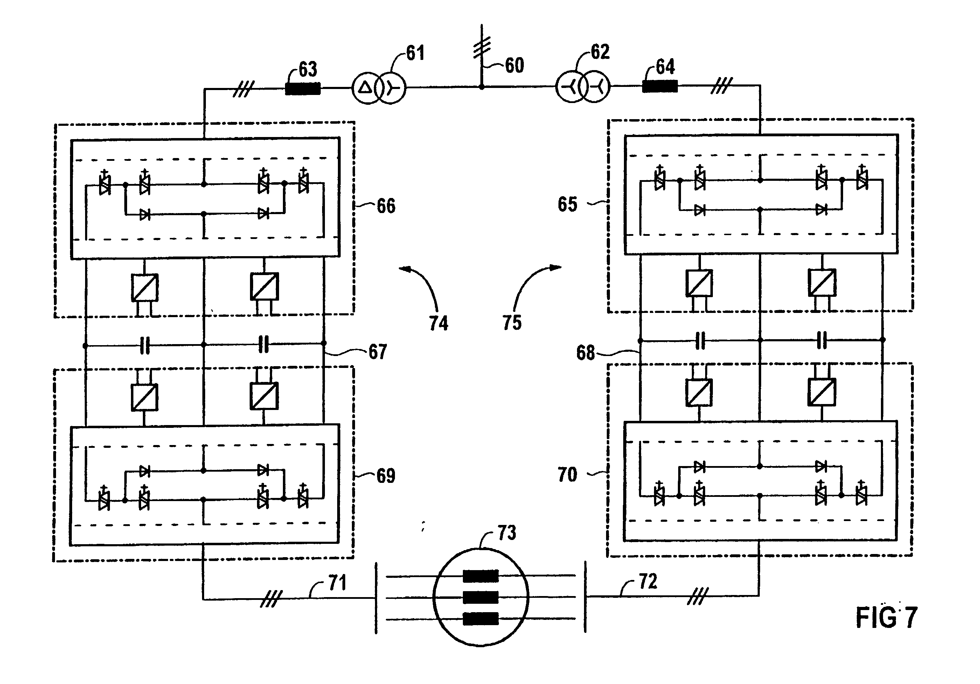

Bei der Anordnung in FIG 7 ist ein erster Umrichter 74 und ein zweiter Umrichter 75 ausgangsseitig jeweils mit einer Seite 71 und 72 der offenen dreiphasigen Wicklung des Drehstrommotors 73 verbunden. Durch diese Anordnung wird neben einer Leistungsverdoppelung ein besonders vorteilhaftes Betriebsverhalten erreicht, da, entsprechend abgestimmtes Pulsverfahren vorausgesetzt, selbst bei niedriger Schaltfrequenz der GTO-Thyristoren weitgehend sinusförmigen Stromverlauf im Motor mit geringer Oberschwingungsbelastung erreicht wird.

Netzseitig ist der erste Umrichter 74 über eine optionale netzseitige Zusatzinduktivität 63 und einen ersten Transformator 61 z.B. in Stern/Dreieckschaltung mit dem Energieversorgungsnetz 60 verbunden. Der zweite Umrichter 75 ist über eine optionale netzseitige Zusatzinduktivität 64 und einem zweiten Transformator 62 vorteilhafterweise um elektrisch 30° gegenüber dem ersten Transformator 61 versetzt (z.B. in Stern/ Sternschaltung) mit dem Energieversorgungsnetz 60 verbunden. Durch diese Anordnung kommt es am Netz zu besonders günstigen Netzrückwirkungen, insbesondere wenn, wie im vorliegenden Beispiel, die Umrichter aus Teilumrichtern in Dreipunktschaltung bestehen. Es kommt dabei selbst bei Grundschwingungsbelastung der selbstgeführten Netzstromrichter sinusförmigen Stromverlauf mit sehr geringem Oberschwingungsgehalt.

Die beiden Umrichter 74 und 75 weisen jeweils netzseitige Teilumrichter 66 bzw.65 und maschinenseitige Teilumrichter 69 bzw.70 auf, die jeweils über einen Gleichspannungszwischenkreis 67 bzw.68 verbunden sind. Die beiden Gleichspannungszwischenkreise 67 bzw.68 sind voneinander elektrisch getrennt. Alle Teilumrichter 66,65,69,70 sind in Dreipunktschaltung, vorzugsweise mit RC-GTO's, ausgeführt.

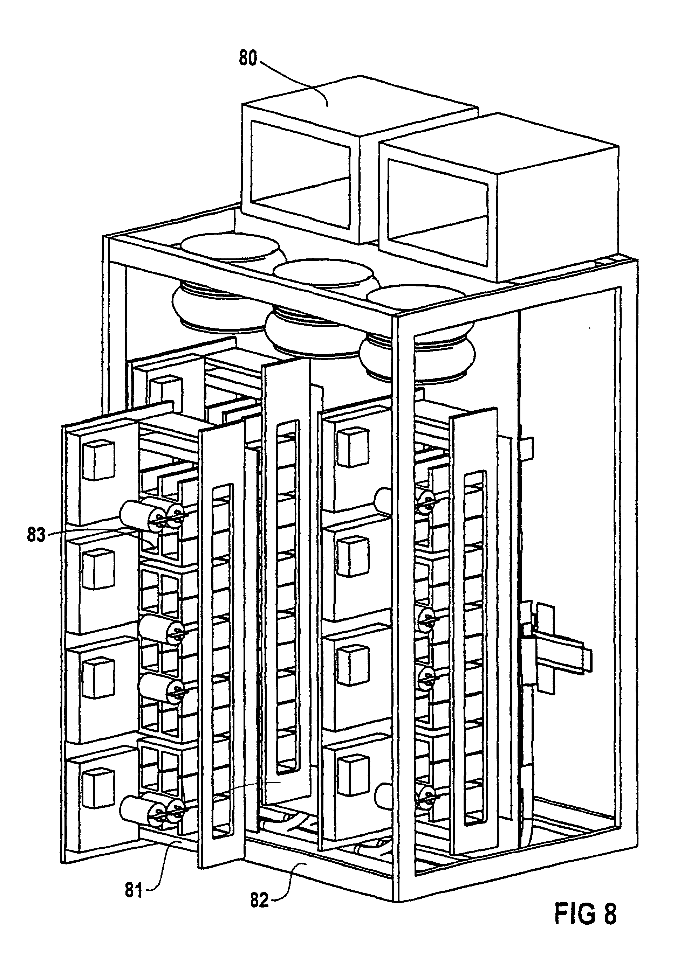

FIG 8 zeigt den mechanischen Aufbau eines erfindungsgemäßen, luftgekühlten Gleichrichters. Die Halbleiterelemente sind im vorliegenden Ausführungsbeispiel auf einem herausziehbaren Gleichrichterbaustein 81 untergebracht. Der Gleichrichterbaustein 81 ist in einen Träger 82 einschiebbar. Der Träger 82 ist in FIG 8 ohne Seitenwände und ohne Türen gezeigt. Die Kühlung erfolgt über einen Luftstrom, der mittels Lüfter 80 erzeugt und den Träger 82 und den eingeschobenen Gleichrichterbaustein 81 durchströmt. Die Halbleiter des Gleichrichterbausteins 81 sind vorteilhafterweise zwischen Kühlkörpern 83 angeordnet, die vom Luftstrom parallel gekühlt werden.

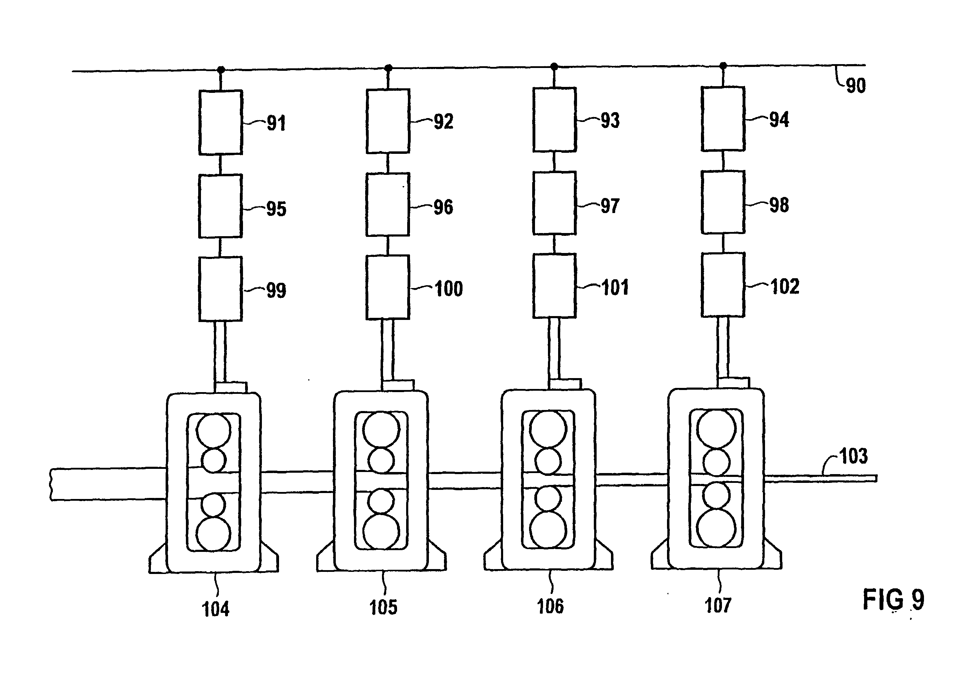

FIG 9 zeigt einen erfindungsgemäßen Umrichter 95,96,97,98 in einem Walzwerk. Das Walzgut 103 wird in den Walzgerüsten 104,105,106,107, die von elektrischen Motoren 99,100,101,102 angetrieben werden, gewalzt. Die Motoren 99,100,101,102 werden über je einen Transformator 91,92,93,94 und je einen erfindungsgemäßen Umrichter 95,96,97,98 durch ein Energieversorgungsnetz 90 gespeist.

## Patentansprüche

1. Antriebseinrichtung für Walzgerüste eines Walzwerkes, wobei die Antriebseinrichtung zumindest einen Drehstrommotor (99,100,101,102) aufweist, der zumindest über einen Umrichter (95,96,97,98) im Megawattbereich, insbesondere in einem Leistungsbereich von 1 bis 20 MW, mittels eines Transformators (91,92,93,94) aus einem Energieversorgungsnetz (90) versorgt wird, wobei jeder Umrichter (95,96,97,98) ein luftgekühlter Spannungszwischenkreis-Umrichter (16) ist, dessen Spannungszwischenkreis (11) und dessen maschinenseitiger Teilstromrichter (12) jeweils als Dreipunkt-Schaltung ausgeführt sind, wobei dieser maschinenseitige Teilstromrichter (12) abschaltbare Leistungshalbleiter aufweist, die mit einer niedrigen bis mittleren Schaltfrequenz arbeiten und jeweils in mehreren Phasenbausteinen räumlich jeweils zwischen zwei Kühlkörper (83) angeordnet sind, und wobei ein Gebläse Umgebungsluft diesen Kühlkörpern (83) der mehreren Phasenbausteinen eines Teilstromrichters (12) zuführt.

2. Antriebseinrichtung nach Anspruch 1, **dadurch gekennzeichnet, dass** als Drehstrommotor (99,100,101,102) der Walzgerüste ein Motor mit offenen Wicklungen vorgesehen ist, die beidseitig von einem luftgekühlten Spannungszwischenkreis-Umrichter (74,75) gespeist werden.

3. Antriebseinrichtung nach Anspruch 1 oder 2, **dadurch gekennzeichnet, dass** der maschinenseitige Teilstromrichter (12) des luftgekühlten Spannungszwischenkreis-Umrichters (16,74,75) ein selbstgeführter Wechselrichter (4) ist.

4. Antriebseinrichtung nach Anspruch 1 oder 2, **dadurch gekennzeichnet, dass** ein netzseitiger Teilstromrichter (10) des luftgekühlten Spannungszwischenkreis-Umrichters (16,74,75) ein selbstgeführter Gleichrichter (6) ist.

5. Antriebseinrichtung nach einem der vorgenannten Ansprüche, **dadurch gekennzeichnet, dass** die Schaltung des selbstgeführten Gleichrichters (6) gleich der Schaltung des selbstgeführten Wechselrichters (4) ist.

6. Antriebseinrichtung nach Anspruch 1 oder 2, **dadurch gekennzeichnet, dass** der netzseitige Teilstromrichter (10) des luftgekühlten Spannungszwischenkreis-Umrichters (16,74,75) ein Diodengleichrichter (2) ist.

7. Antriebseinrichtung nach Anspruch 6, **dadurch gekennzeichnet, dass** der Diodengleichrichter (2) zwei elektrisch in Reihe geschaltete B6-Diodenbrücken aufweist.

8. Antriebseinrichtung nach einem der vorgenannten Ansprüche, **dadurch gekennzeichnet, dass** die abschaltbaren Leistungshalbleiter rückwärts leitend ausgebildet sind.

9. Antriebseinrichtung nach einem der vorgenannten Ansprüche, **dadurch gekennzeichnet, dass** als abschaltbare Leistungshalbleiter abschaltbare Thyristoren (V₁,V₂,V₃,V₄) vorgesehen sind.

## Claims

1. Drive device for roll stands of a rolling mill, the drive device having at least one three-phase AC motor (99,100,101,102) which is supplied from an electricity supply network (90) at least via a converter (95,96,97,98) in the megawatt range, in particular in a power range from 1 to 20 MW, by means of a transformer (91,92,93,94), each converter (95,96,97,98) being an air-cooled voltage intermediate circuit converter (16) whose voltage intermediate circuit (11) and whose machine-side converter section (12) are each designed as a three-point circuit, this machine-side converter section (12) having turn-off power semiconductors which operate at a low to medium switching rate and are spatially arranged in each case in a plurality of phase modules, between two heat sinks (83) in each case, and a fan feeding ambient air to these heat sinks (83) of the plurality of phase modules of a converter section (12).

2. Drive device according to Claim 1, **characterized in that** provided as three-phase AC motor (99,100,101,102) of the roll stands is a motor with open windings which are fed on both sides by an air-cooled voltage intermediate circuit converter (74,75).

3. Drive device according to Claim 1 or 2, **characterized in that** the machine-side converter section (12) of the air-cooled voltage intermediate circuit converter (16,74,75) is a self-commutated inverter (4).

4. Drive device according to Claim 1 or 2, **characterized in that** a network-side converter section (10) of the air-cooled voltage intermediate circuit converter (16,74,75) is a self-commutated rectifier (6).

5. Drive device according to one of the preceding claims, **characterized in that** the circuit of the self-commutated rectifier (6) is identical to the circuit of the self-commutated inverter (4).

6. Drive device according to Claim 1 or 2, **characterized in that** the network-side converter section (10) of the air-cooled voltage intermediate circuit converter (16,74,75) is a diode rectifier (2).

7. Drive device according to Claim 6, **characterized in that** the diode rectifier (2) has two B6 diode bridges connected electrically in series.

8. Drive device according to one of the preceding claims, **characterized in that** the turn-off power semiconductors are designed to be reverse conducting.

9. Drive device according to one of the preceding claims, **characterized in that** turn-off thyristors (V₁,V₂,V₃,V₄) are provided as turn-off power semiconductors.

## Revendications

1. Dispositif d'entraînement pour cages de laminoir, le dispositif d'entraînement comportant au moins un moteur triphasé (99, 100, 101, 102) qui est alimenté au moins par l'intermédiaire d'un convertisseur (95, 96, 97, 98) dans une plage de puissance de l'ordre des mégawatts, notamment dans une plage de puissance allant de 1 à 20 MW, au moyen d'un transformateur (91, 92, 93, 94) à partir d'un réseau d'alimentation en énergie (90), chaque convertisseur (95, 96, 97, 98) étant un convertisseur à circuit intermédiaire de tension (16) refroidi par air dont le circuit intermédiaire de tension (11) et le convertisseur partiel côté moteur (12) sont réalisés respectivement selon un montage à trois points, ce convertisseur partiel côté moteur (12) comportant des semi-conducteurs de puissance interruptibles qui fonctionnent avec une fréquence de commutation petite à moyenne et qui sont disposés respectivement dans plusieurs composants de phase, dans l'espace respectivement entre deux corps de refroidissement (83), et un ventilateur envoyant de l'air ambiant à ces corps de refroidissement (83) des composants de phase d'un convertisseur partiel (12).

2. Dispositif d'entraînement selon la revendication 1, **caractérisé par le fait qu'**il est prévu comme moteur triphasé (99, 100, 101, 102) des cages de laminoir un moteur avec des enroulements ouverts qui sont alimentés des deux côtés par un convertisseur à circuit intermédiaire de tension (74, 75) refroidi par air.

3. Dispositif d'entraînement selon la revendication 1 ou 2, **caractérisé par le fait que** le convertisseur partiel côté moteur (12) du convertisseur à circuit intermédiaire de tension (16, 74, 75) refroidi par air est un onduleur autocommuté (4).

4. Dispositif d'entraînement selon la revendication 1 ou 2, **caractérisé par le fait qu'**un convertisseur partiel côté réseau (10) du convertisseur à circuit intermédiaire de tension (16, 74, 75) refroidi par air est un redresseur autocommuté (6).

5. Dispositif d'entraînement selon l'une des revendications précédentes, **caractérisé par le fait que** le circuit du redresseur autocommuté (6) est identique au circuit de l'onduleur autocommuté (4).

6. Dispositif d'entraînement selon la revendication 1 ou 2, **caractérisé par le fait que** le convertisseur partiel côté réseau (10) du convertisseur à circuit intermédiaire de tension (16, 74, 75) refroidi par air est un redresseur à diodes (2).

7. Dispositif d'entraînement selon la revendication 6, **caractérisé par le fait que** le redresseur à diodes (2) comporte deux ponts de diodes du type B6 branchés électriquement en série.

8. Dispositif d'entraînement selon l'une des revendications précédentes, **caractérisé par le fait que** les semi-conducteurs de puissance interruptibles sont à conduction inverse.

9. Dispositif d'entraînement selon l'une des revendications précédentes, **caractérisé par le fait que** des thyristors interruptibles (V₁, V₂, V₃, V₄) sont prévus comme semi-conducteurs de puissance interruptibles.
